# DEMANDE DE BREVET EUROPEEN

(11) **EP 2 146 432 A1**
(43) Date de publication de la demande: **20.01.2010**
(21) Numéro de dépôt: 08160648.5
(22) Date de dépôt: 17.07.2008
(51) Int. Cl.: H03K 19/00, G06F 1/00

(54) **Dispositif de sauvegarde de la configuration de terminaux d'un circuit intégré, et procédé de mise en action du dispositif**

(71) Demandeur: EM Microelectronic-Marin SA, 2074 Marin (CH)
(72) Inventeur: Théoduloz, Yves, 1400 Yverdon (CH); Jaeggi, Hugo, 2046 Fontaines (CH); Plavec, Lubomir, 262 13 Necin (CZ)
(74) Mandataire: Couillard, Yann Luc Raymond

(57) **Abrégé**

Le dispositif (1) du circuit intégré permet de sauvegarder la configuration de terminaux de sortie (0, S_{P}) dudit circuit intégré dans un mode basse consommation. Pour ce faire, le dispositif comprend plusieurs unités à décalage de niveau de tension (2, 2', 2", 2"') et un étage de sortie (3) relié à chaque sortie des unités à décalage du niveau et relié à au moins une plage de contact externe (S_{P}) dudit circuit intégré. Chaque unité à décalage du niveau comprend un étage d'entrée alimenté sous une tension régulée interne (V_{REG}) et une partie de transfert d'un état d'une fonction spécifique en sortie, qui est alimentée sous une tension d'alimentation (V_{DD}) du circuit intégré. Chaque unité à décalage de niveau comprend également une cellule mémoire en sortie alimentée par la tension d'alimentation, pour mémoriser l'état de sortie d'une fonction spécifique de l'unité à décalage de niveau dans un mode de repos du circuit intégré où la tension régulée est coupée.

## Description

L'invention concerne un dispositif de sauvegarde de la configuration de terminaux d'un circuit intégré à basse consommation. Le dispositif de sauvegarde comprend au moins une unité à décalage de niveau de tension, qui comprend un étage d'entrée alimenté sous une tension régulée interne et une partie de transfert d'un état d'une fonction en sortie, qui est alimentée sous une tension d'alimentation du circuit intégré. Le dispositif de sauvegarde comprend également un étage de sortie alimenté sous la tension d'alimentation du circuit intégré, qui est relié à la sortie de l'unité à décalage de niveau de tension et connecté à au moins une plage de contact externe du circuit intégré.

L'invention concerne également un procédé de mise en action du dispositif de sauvegarde de la configuration de terminaux d'un circuit intégré à basse consommation.

On entend par terminal toute borne de sortie d'unités électroniques d'un circuit intégré, ainsi qu'une liaison à une plage de contact externe dudit circuit intégré.

Habituellement pour pouvoir diminuer la consommation électrique d'un circuit intégré par exemple dans un mode de repos, il existe différents moyens électroniques connus. Il peut être envisagé par exemple de couper la tension d'alimentation du circuit intégré. Dans ce mode de coupure de l'alimentation (power down en terminologie anglaise), l'état des fonctions intégrées dans ledit circuit intégré n'est plus garanti, ce qui fait que les terminaux de sortie perdent leur configuration. Il doit donc être pris certaines précautions spécifiques depuis l'extérieur du circuit intégré pour s'assurer des problèmes d'incompatibilité entre les terminaux. Cela peut nécessiter l'ajout d'un élément de tirage vers le haut ou d'un élément de tirage vers le bas.

Le document de brevet JP 2003-295988 décrit un circuit intégré muni de moyens pour réduire la consommation électrique dudit circuit intégré dans un mode de repos. Pour ce faire, il comprend au moins une unité à décalage du niveau de tension, qui est alimentée d'une part par une tension régulée interne, et d'autre part par une tension haute d'alimentation du circuit intégré. Le circuit intégré comprend également entre l'unité à décalage du niveau de tension et une plage de contact externe, une cellule mémoire. De cette manière, la configuration d'un terminal de sortie est maintenue dans un mode basse consommation par ladite cellule mémoire.

Pour mémoriser l'état d'un terminal de sortie du circuit intégré de ce document de brevet JP 2003-295988, le logiciel du circuit intégré opère en deux étapes. Une première étape est de tout d'abord mémoriser dans la cellule mémoire l'état du terminal de sortie, et une seconde étape est de passer en mode basse consommation en laissant dans un état flottant les parties alimentées par la tension régulée interne, qui est déconnectée. Cependant le circuit intégré proposé ne peut s'appliquer qu'à la mémorisation de l'état d'un seul terminal de sortie. Dans le cas de la sauvegarde en sortie de la configuration de plusieurs terminaux relatifs à plusieurs fonctions spécifiques, ce circuit intégré devrait comprendre plusieurs blocs fonctionnels en plus. L'ajout de ces blocs fonctionnels complique la conception du circuit intégré, car il doit être garanti également dans le circuit intégré de bons niveaux logiques lors du passage du mode de repos au mode de fonctionnement normal.

L'invention a donc pour but de fournir un dispositif de sauvegarde de la configuration de terminaux d'un circuit intégré dans un mode basse consommation ou de repos tout en évitant une surconsommation dans ce mode de repos et en palliant les inconvénients de l'état de la technique cité.

A cet effet, l'invention concerne un dispositif de sauvegarde de la configuration de terminaux d'un circuit intégré à basse consommation cité ci-devant, qui comprend les caractéristiques définies dans la revendication indépendante 1.

Des formes d'exécution particulières du dispositif de sauvegarde sont définies dans les revendications dépendantes 2 à 7.

Un avantage du dispositif de sauvegarde réside dans le fait que dans le mode basse consommation ou de repos, chaque cellule mémoire des unités à décalage du niveau de tension mémorise l'état du terminal de sortie correspondant. Pour ce faire, un signal de mémorisation est appliqué à chaque cellule mémoire en même temps pour commander la mémorisation de l'état de chaque terminal de sortie des unités à décalage du niveau. Ce signal de mémorisation doit intervenir avant le passage du mode de fonctionnement normal au mode de repos.

Un avantage supplémentaire du dispositif de sauvegarde réside dans le fait que dans le mode basse consommation ou de repos, des moyens de blocage sont prévus dans la partie de transfert d'un état en sortie dans chaque unité à décalage du niveau de tension. Ces moyens de blocage permettent de couper tous les courants transversaux de la partie de transfert et peuvent fixer un état défini en sortie de chaque unité. Ces courants transversaux apparaissent du fait que la tension régulée interne est placée dans un état flottant sans garantir un blocage de tous les transistors de chaque unité. Ainsi, ils subsistent des noeuds flottants de transistors dans cette partie de transfert, ce qui peut induire les courants transversaux. Grâce à ces moyens de blocage, cela permet de n'avoir que des courants de fuites des éléments alimentés par la tension d'alimentation du circuit intégré dans ce mode de repos.

L'invention concerne encore un procédé de mise en action du dispositif de sauvegarde de la configuration de terminaux d'un circuit intégré à basse consommation cité ci-devant, qui comprend les caractéristiques définies dans la revendication indépendante 8.

Des étapes particulières du procédé de mise en action du dispositif de lecture sont définies dans les revendications dépendantes 9 et 10.

Un avantage du procédé de mise en action du dispositif de sauvegarde réside dans le fait qu'une fois que la configuration des terminaux de sortie des unités à décalage du niveau de tension est mémorisée, il est possible de passer dans un mode basse consommation. Chaque cellule mémoire desdites unités à décalage du niveau de tension, maintient l'état de sortie jusqu'à ce que le dispositif de sauvegarde passe du mode de repos au mode de fonctionnement normal. Dans le mode basse consommation, tous les courants transversaux sont supprimés dans les unités à décalage du niveau de tension par des moyens de blocage, ce qui garantit une faible consommation du circuit intégré.

Les buts, avantages et caractéristiques du dispositif de sauvegarde de la configuration de terminaux d'un circuit intégré à basse consommation, et de son procédé de mise en action apparaîtront mieux dans la description suivante de manière non limitative d'au moins une forme d'exécution illustrée par les dessins sur lesquels :
la figure 1 représente de manière simplifiée les éléments du dispositif de sauvegarde de la configuration des terminaux du circuit intégré selon l'invention,
la figure 2 représente de manière simplifiée une unité à décalage du niveau de tension qui comprend une cellule mémoire du dispositif de sauvegarde selon l'invention, et
la figure 3 représente une forme d'exécution détaillée d'une unité à décalage du niveau de tension ayant une cellule mémoire du dispositif de sauvegarde selon l'invention.

Dans la description suivante, toutes les parties du dispositif de sauvegarde de la configuration de terminaux d'un circuit intégré à basse consommation, qui sont bien connues d'un homme du métier dans ce domaine technique, ne sont relatées que de manière simplifiée.

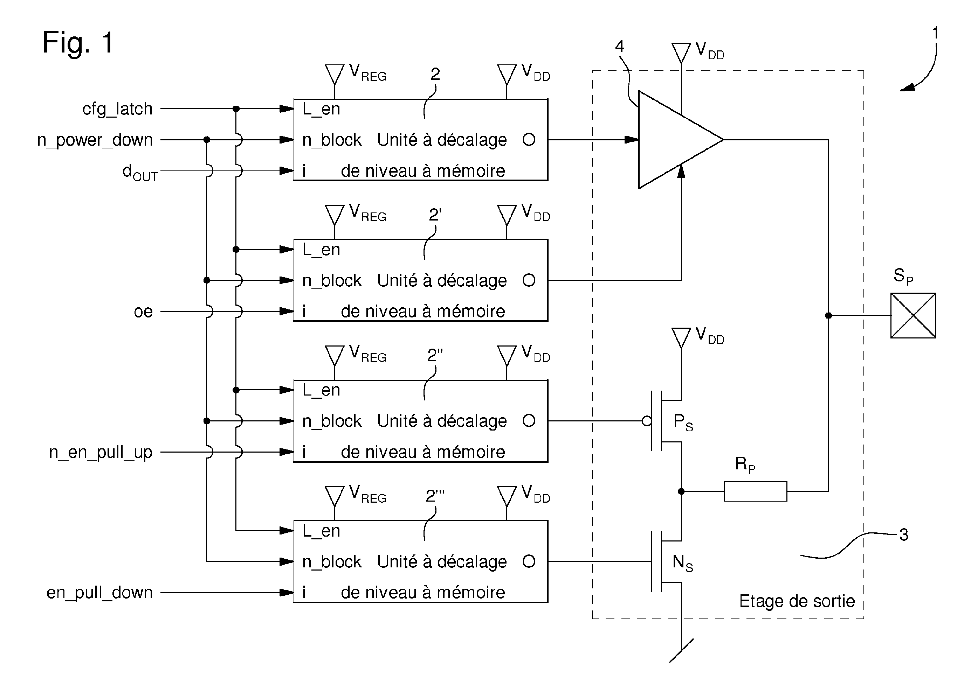

La figure 1 représente un dispositif de sauvegarde 1 de la configuration de terminaux de sortie d'un circuit intégré. Ce dispositif de sauvegarde comprend un ensemble d'unités à décalage du niveau de tension 2, 2', 2" et 2"' et un étage de sortie 3 disposé entre chaque sortie O de chaque unité et au moins une plage de contact externe S_{P} du circuit intégré. Chaque unité à décalage du niveau de tension comprend un étage d'entrée et une partie de transfert d'un état d'une fonction en sortie non représentés. L'étage d'entrée de chaque unité est alimenté par une tension régulée interne V_{REG}, alors que la partie de transfert d'un état d'une fonction est toujours alimentée à une tension d'alimentation V_{DD} du circuit intégré, qui peut être de niveau supérieur ou inférieur à la tension régulée. L'étage d'entrée est prévu pour recevoir à une entrée i des signaux de données ou de contrôle D_{OUT}, oe, n_en_pull_up et en_pull_down relatifs à la fonction de chaque unité en liaison par l'étage de sortie à la plage de contact externe S_{P}. Ces signaux de données ou de contrôle proviennent d'une partie logique non représentée du circuit intégré du domaine de la tension régulée interne.

Dans la configuration représentée à la figure 1, le dispositif de sauvegarde est capable de mettre en fonction la fourniture de données d_{OUT} en sortie (Output Enable en terminologie anglaise) par l'intermédiaire d'une première unité à décalage du niveau 2. La sortie O de cette première unité à décalage du niveau, qui est dans le domaine de la tension d'alimentation V_{DD} du circuit intégré, est fourni à une porte de transfert à trois états 4 (buffer tristate en terminologie anglaise) de l'étage de sortie 3, afin de transmettre ces données par la plage de contact externe S_{P}. La porte de transfert, qui est alimentée à la tension d'alimentation du circuit intégré, est mise en fonction par un signal de contrôle oe fourni en entrée d'une seconde unité à décalage du niveau 2' et décalé en tension en sortie O de la seconde unité.

Une troisième unité à décalage du niveau de tension 2" est prévue pour la fonction de tirage vers le haut de la plage de contact externe, alors qu'une quatrième unité à décalage du niveau de tension 2"' est prévue pour la fonction de tirage vers le bas de la plage de contact externe S_{P}. Pour ce faire, la sortie O de la troisième unité à décalage du niveau 2" est reliée à une grille d'un transistor PMOS P_{S} de l'étage de sortie 3, alors que la sortie O de la quatrième unité à décalage du niveau 2"' est reliée à la grille d'un transistor NMOS N_{S} de l'étage de sortie 3. Ces deux transistors sont reliés en série entre la borne de la tension d'alimentation V_{DD} et la borne de masse. Le noeud de connexion des drains des deux transistors P_{S} et N_{S} est relié par l'intermédiaire d'une résistance de charge R_{P} à la plage de contact externe S_{P}.

Cependant les troisième et quatrième unités à décalage du niveau de tension ne doivent pas commander le tirage vers le haut ou le tirage vers le bas, lors d'un transfert de données par la première unité à décalage du niveau de tension 2, quand le signal de contrôle oe est à l'état "1", par exemple proche de V_{REG}. De plus quand un tirage vers le haut est commandé avec un signal de contrôle n_en_pull_up à l'état "0" par la troisième unité à décalage 2", le transistor P_{S} devient conducteur, alors que le transistor N_{S} doit rester non conducteur avec le signal de contrôle en_pull_down à l'état "0". Quand un tirage vers le bas est commandé avec le signal de contrôle en_pull_down à l'état "1" par la quatrième unité à décalage 2'", le transistor N_{S} devient conducteur, alors que le transistor P_{S} doit rester non conducteur avec le signal de contrôle n_en_pull_up à l'état "1", par exemple proche de V_{REG}.

Il doit être pris garde lors du passage d'une fonction de tirage vers le haut à une fonction de tirage vers le bas ou inversement, pour ne pas avoir les deux transistors conducteurs. Un temps de pause doit généralement être observé dans lequel les deux transistors P_{S} et N_{S} sont non conducteurs avant d'opérer le changement de fonction souhaité.

Chaque unité à décalage du niveau de tension destinée à remplir une fonction spécifique comprend en plus d'un circuit traditionnel à décalage du niveau de tension, une cellule mémoire non représentée à la figure 1. Cette cellule mémoire est commandée par le signal de mémorisation cfg_latch fourni à l'entrée L_en de chaque unité afin de maintenir l'état du terminal de sortie O de chaque unité avant le passage dans un mode de repos. Ce signal de mémorisation et la cellule mémoire sont dans le domaine de la tension d'alimentation V_{DD} du circuit intégré, qui est toujours active dans un mode de repos et dans un mode de fonctionnement normal du circuit intégré.

De manière à supprimer tout courant transversal lors du passage dans un mode de repos après avoir mémorisé l'état de chaque terminal de sortie par l'intermédiaire de chaque cellule mémoire, chaque unité à décalage 2, 2', 2", 2"' comprend encore des moyens de blocage non représentés, qui fonctionnent dans le domaine de la tension d'alimentation V_{DD}. Un signal de blocage n_power_down est fourni en même temps à chaque entrée n_block de chaque unité à décalage du niveau. Grâce à ces moyens de blocage, uniquement des courants de fuites des éléments alimentés par la tension d'alimentation du circuit intégré subsistent dans ce mode de repos.

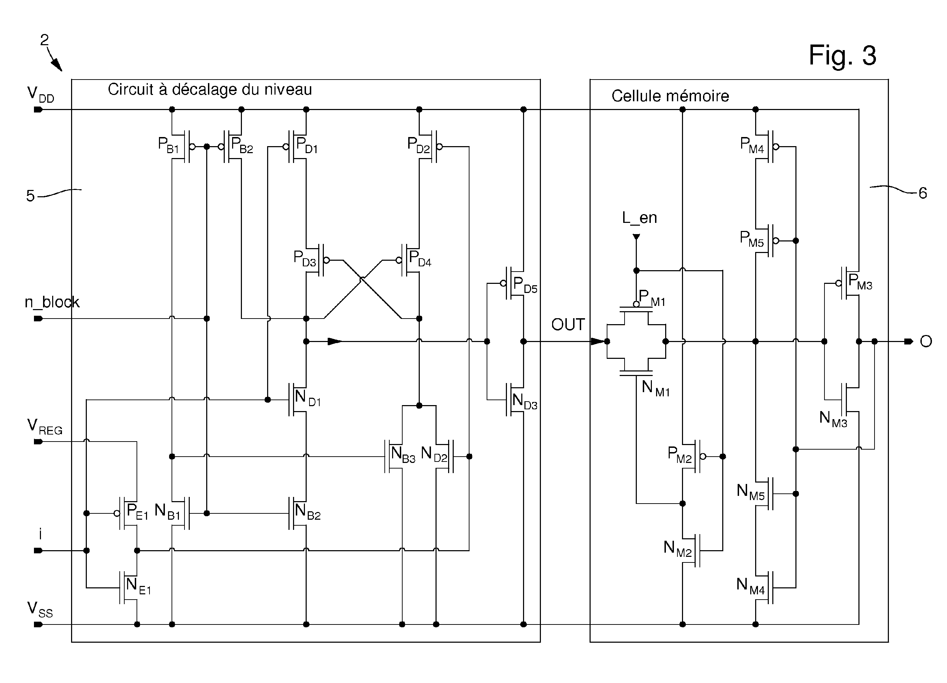

Normalement comme décrit en référence à la figure 3 ci-après, les moyens de blocage deviennent actifs quand le signal n_block est à l'état "0". Dans un mode de fonctionnement normal du circuit intégré, ce signal n_block doit être par contre à l'état "1" par exemple proche de V_{DD}. Ceci permet un transfert du signal de données ou de contrôle par l'unité à décalage du niveau de tension du domaine de la tension régulée V_{REG} au domaine de la tension d'alimentation V_{DD}.

Même s'il n'est représenté que quatre unités à décalage du niveau de tension à la figure 1, il peut tout à fait être concevable d'ajouter encore certaines unités à décalage du niveau de tension en parallèle. Il peut être prévu par exemple une ou plusieurs unités à décalage du niveau de tension pour recevoir des données (Input Enable en terminologie anglaise) par la plage de contact externe S_{P}. De ce fait en liaison à la plage de contact externe du circuit intégré, il peut être prévu une sortie numérique de données, une entrée numérique de données, une entrée numérique avec tirage vers le haut ou vers le bas, un état à drain ouvert et une sortie à trois états en mode analogique. Cependant de manière à ne pas surcharger la figure 1, uniquement quatre unités à décalage ont été représentées et décrites.

Le procédé de mise en action du dispositif de sauvegarde de la configuration des terminaux de sortie du circuit intégré peut être décrit pour le passage du mode de fonctionnement normal à un mode de repos et inversement. Dans une première étape dans le mode de fonctionnement normal, le signal de mémorisation L_en doit passer d'un état "0" à un état "1" pour commander l'opération de mémorisation par les cellules mémoires du dernier état de sortie de chaque unité à décalage du niveau de tension. Une fois que ce signal de mémorisation L_en est à l'état "1", tout changement du signal d'entrée i n'a plus aucune influence sur l'état en sortie de chaque unité à décalage 2, 2', 2" et 2"'.

Dans une seconde étape du procédé, la logique du circuit intégré commande le passage du mode de fonctionnement normal au mode basse consommation ou de repos. Dans ce mode de repos la tension régulée interne est coupée ou devient flottante, ce qui a pour conséquence une réduction de consommation électrique du circuit intégré de toutes les parties alimentées par cette tension régulée interne V_{REG}. Toutefois l'état de tous les terminaux de sortie des parties alimentées par la tension d'alimentation V_{DD}, est maintenu par le biais des cellules mémoires. Le signal de mémorisation L_en est de ce fait toujours maintenu à l'état "1 ".

Dans une troisième étape du procédé, le dispositif de sauvegarde est réveillé pour le passage du mode de repos au mode de fonctionnement normal. Dans cette troisième étape du procédé, la configuration des terminaux de sortie est toujours maintenue par les cellules mémoires commandées par le signal de mémorisation L_en à l'état "1", par exemple proche de V_{DD}.

Finalement dans une quatrième étape du procédé, le signal de mémorisation passe de l'état "1" à l'état "0". Dans cette condition, la configuration des terminaux de sortie peut changer en fonction des signaux de données ou de contrôle à l'entrée de chaque unité à décalage du niveau de tension.

S'il est prévu dans chaque unité à décalage du niveau de tension, des moyens de blocage des courants transversaux, ces moyens de blocage deviennent fonctionnels uniquement après la mémorisation de la configuration des terminaux de sortie, c'est-à-dire après la première étape du procédé. Les moyens de blocage peuvent être activés soit avant la seconde étape du procédé, soit au même moment ou légèrement après la seconde étape du procédé en fonction de la partie logique configurée du circuit intégré. Pour ce faire, le signal n_block doit passer de l'état "1" à l'état "0".

Les moyens de blocage des courants transversaux peuvent devenir inactifs après la troisième étape du procédé avec le signal n_block qui passe de l'état "0" à l'état "1 ". Ceci permet de pouvoir à nouveau transférer le signal de données ou de contrôle de l'étage d'entrée en sortie de la partie de transfert de chaque unité à décalage du niveau de tension.

Toutes les étapes du procédé de mise en action du dispositif de sauvegarde sont simples à concevoir avec une temporisation de tous les signaux, qui est contrôlée par logiciel. Il n'est ainsi prévu aucun ajout de blocs fonctionnels complémentaires, ce qui peut compliquer la conception du circuit intégré. De plus grâce au dispositif de sauvegarde de la présente invention, de bons niveaux logiques sont garantis par exemple lors du passage du mode de repos au mode de fonctionnement normal.

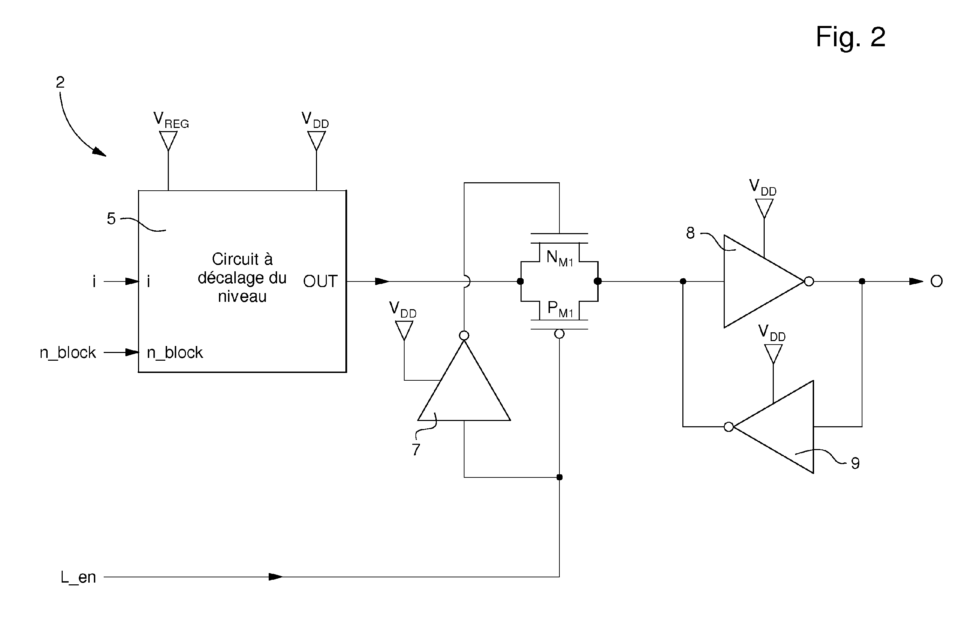

A la figure 2, il est représenté de manière schématique une unité à décalage du niveau de tension 2. Cette unité à décalage, déjà décrite en référence à la figure 1, comprend principalement un circuit à décalage du niveau de tension 5, qui peut être de conception traditionnelle en fonctionnement normal, et une cellule mémoire reliée en sortie OUT du circuit à décalage du niveau 5. Le circuit à décalage du niveau de tension 5 comprend un étage d'entrée recevant un signal de données ou de contrôle i, qui est alimenté par la tension régulée V_{REG}, et une partie de transfert d'un état d'une fonction en sortie OUT, qui est alimenté par la tension d'alimentation V_{DD} du circuit intégré. Cette partie de transfert comprend également en plus de la partie à décalage du niveau de tension traditionnel, les moyens de blocage des courants transversaux, qui seront décrits ci-après en détail en référence à la figure 3.

Il est à noter que l'état d'une fonction en sortie OUT dans la partie de transfert concerne le décalage en tension d'un signal de données i ou d'un signal de contrôle i. L'état de la sortie OUT est par contre bloqué à l'état "0" si le signal n_block est à l'état "0" quelque que soit le signal de données ou de contrôle en entrée i.

La cellule mémoire de l'unité à décalage du niveau de tension est composée de manière traditionnelle tout d'abord d'une paire de transistors NMOS N_{M1} et PMOS P_{M1} de conductivité différente montés en parallèle. La grille du premier transistor P_{M1} est commandée par le signal de mémorisation L_en, alors que la grille du second transistor N_{M1} est commandée par l'inverse du signal de mémorisation L_en. Pour ce faire, un premier inverseur rapide 7 est relié d'un côté à la grille du premier transistor P_{M1} et en sortie à la grille du second transistor N_{M1}. Ce premier inverseur est alimenté à la tension d'alimentation V_{DD} du circuit intégré.

Les drains de ces deux transistors NMOS N_{M1} et PMOS P_{M1} sont reliés en sortie OUT du circuit à décalage du niveau 5, alors que les sources de ces deux transistors sont reliées en entrée d'un second inverseur rapide 8 alimenté à la tension d'alimentation V_{DD}. La sortie de ce second inverseur est la sortie O de l'unité à décalage du niveau de tension. Un troisième inverseur faible 9 est encore relié entre la sortie O et l'entrée du second inverseur 8. Ce troisième inverseur faible 9 est également alimenté à la tension d'alimentation V_{DD}.

Le principe de mémorisation d'un état du terminal O par l'intermédiaire de la cellule mémoire ne sera pas expliqué en détail, car il fait partie des connaissances générales d'un homme du métier dans ce domaine technique. Il est juste noté que pour mémoriser un état en sortie de l'unité à décalage du niveau de tension, il est nécessaire que le signal de mémorisation L_en soit maintenu dans un état "1", c'est-à-dire normalement à la tension d'alimentation V_{DD}. Quand le signal L_en est à l'état "1", les deux transistors sont rendus non conducteurs pour la mémorisation d'un état de sortie au niveau de leur borne de source.

L'unité à décalage du niveau de tension est expliquée maintenant de manière plus détaillée en référence à la figure 3. Sur cette figure 3, on reconnaît principalement le circuit à décalage du niveau 5 et la cellule mémoire 6 comme décrits précédemment.

L'unité à décalage du niveau de tension 2 comprend tout d'abord un étage d'entrée alimenté à la tension régulée V_{REG}. Cet étage d'entrée est composé d'un inverseur ayant deux transistors PMOS P_{E1} et NMOS N_{E1} de conductivité différente connectés en série entre la borne de tension régulée V_{REG} et la borne de masse V_{SS}. La source du transistor P_{E1} est reliée à la borne de la tension régulée, alors que la source du transistor N_{E1} est reliée à la borne de masse. La grille de ces deux transistors P_{E1} et N_{E1} est commandée par le signal de données ou de contrôle i. Ce signal de données ou de contrôle commande également un premier transistor NMOS N_{D1} par sa grille et un premier transistor PMOS P_{D1} par sa grille de la partie de décalage du niveau de tension pour le transfert d'un état en sortie. Le noeud de connexion des drains de ces transistors d'entrée P_{E1} et N_{E1} est relié à la grille d'un second transistor NMOS N_{D2} et à la grille d'un second transistor PMOS P_{D2} de la partie de décalage du niveau traditionnel.

La partie à décalage du niveau de tension comprend donc le premier transistor PMOS P_{D1}, dont la source est reliée à la borne de la tension d'alimentation V_{DD}, le second transistor PMOS P_{D2}, dont la source est également reliée à la borne de la tension d'alimentation V_{DD}. Cette partie à décalage du niveau de tension comprend également une paire différentielle de transistors du type PMOS P_{D3} et P_{D4}, qui est une partie bistable bien connue. La source du troisième transistor P_{D3} est reliée au drain du premier transistor PMOS P_{D1} alors que la source du quatrième transistor P_{D4} est reliée au drain du second transistor PMOS P_{D2}. La grille du troisième transistor PMOS P_{D3} est reliée au drain du quatrième transistor P_{D4} et également au drain du second transistor NMOS N_{D2}, alors que la grille du quatrième transistor P_{D4} est reliée au drain du troisième transistor P_{D3}, ainsi qu'au drain du premier transistor NMOS N_{D1}. La source du second transistor NMOS N_{D2} est directement reliée à la borne de masse V_{SS}, alors que la source du premier transistor N_{D1}, qui devrait traditionnellement être reliée à la borne de masse, est par contre reliée au drain d'un transistor de blocage N_{B2} des moyens de blocage.

Le noeud de connexion du drain du premier transistor NMOS N_{D1} et du drain du troisième transistor PMOS P_{D3} est relié à un inverseur de sortie, qui fournit le signal de sortie OUT. Cet inverseur de sortie est composé de deux transistors PMOS P_{D5} et NMOS N_{D3} de conductivité différente, connectés en série entre la borne de tension d'alimentation V_{DD} et la borne de masse V_{SS}. La source du cinquième transistor PMOS P_{D5} est reliée à la borne de la tension d'alimentation V_{DD}, alors que la source du troisième transistor NMOS N_{D3} est reliée à la borne de masse. La grille de ces deux transistors P_{D5} et N_{D3} est commandée par le noeud de connexion des drains des transistors P_{D3} et N_{D1}, alors que le noeud de connexion des drains de ces deux transistors P_{D5} et N_{D3} constitue la borne de sortie OUT du circuit à décalage du niveau.

Les moyens de blocage font partie, dans le circuit à décalage du niveau 5, de la partie de transfert d'un état d'une fonction en sortie. Ces moyens de blocage comprennent tout d'abord des premier, second et troisième transistors NMOS N_{B1}, N_{B2} et N_{B3}, dont la source de chacun est directement reliée à la borne de masse V_{SS}, et des premier et second transistors PMOS P_{S1} et P_{B2}, dont la source de chacun est directement reliée à la borne de la tension d'alimentation V_{DD}.

La grille des premier et second transistors NMOS N_{B1} et N_{B2} est reliée à la grille des premier et second transistors PMOS P_{S1} et P_{B2}. La grille de ces transistors est commandée directement par le signal de blocage n_block. Le drain du premier transistor PMOS P_{B1} est relié au drain du premier transistor NMOS N_{B1}, ainsi qu'à la grille du troisième transistor NMOS N_{B3}. Le drain du troisième transistor NMOS N_{B3} est relié au drain du second transistor NMOS N_{D2}, au drain du quatrième transistor PMOS P_{D4} et à la grille du troisième transistor PMOS P_{D3} de la partie à décalage du niveau. Le drain du second transistor NMOS N_{B2} de blocage est relié à la source du premier transistor NMOS N_{D1} de la partie à décalage du niveau. Finalement le drain du second transistor PMOS P_{B2} de blocage est relié au noeud de connexion du drain du premier transistor NMOS N_{D1}, du drain du troisième transistor PMOS P_{D3} et de la grille du quatrième transistor PMOS P_{D4} de la partie à décalage du niveau.

Lorsque le signal de blocage n_block est à l'état "1", c'est-à-dire par exemple au niveau de la tension d'alimentation V_{DD}, le circuit à décalage du niveau fonctionne de manière traditionnelle. Les premier et second transistors NMOS N_{B1} et N_{B2} sont conducteurs ce qui permet de relier la source du premier transistor NMOS N_{D1} à la borne de masse et de rendre non conducteur le troisième transistor NMOS N_{B3} de blocage. Les deux transistors de blocage P_{S1} et P_{B2} sont par contre non conducteurs.

Pour garantir un blocage dans le circuit à décalage du niveau de tous les transistors dans un état bien défini pour n'avoir que des courants de fuites dans le mode basse consommation, le signal de blocage n_block est commandé par la logique du circuit intégré pour être dans un état "0" proche de la masse. Lorsque le signal de blocage n_block est à l'état "0", les deux transistors de blocage PMOS P_{S1} et P_{B2} deviennent conducteurs, alors que les deux transistors de blocage NMOS N_{B1} et N_{B2} deviennent non conducteurs. Le troisième transistor de blocage NMOS N_{B3} devient conducteur pour tirer la grille du troisième transistor PMOS P_{D3} et le drain du quatrième transistor PMOS P_{D4} vers la masse. Le second transistor de blocage PMOS P_{B2} devient conducteur et tire le noeud de connexion du drain du premier transistor NMOS N_{D1}, du drain du troisième transistor PMOS P_{D3} et de la grille du quatrième transistor PMOS P_{D4} de la partie à décalage du niveau, vers le haut à la tension d'alimentation V_{DD}. Ainsi la sortie OUT du circuit à décalage est bloqué à un état "0", quelque soit l'état du signal de données ou de contrôle i.

La cellule mémoire 6, qui est reliée à la sortie OUT du circuit à décalage du niveau de tension 5, comprend les mêmes éléments que ceux décrits en référence à la figure 2. De ce fait uniquement les inverseurs reliés à la paire de transistors P_{M1} et N_{M1}, dont le drain est relié à la sortie OUT, sont décrits en détails.

Le premier inverseur rapide de la cellule mémoire 6 comprend un second transistor PMOS P_{M2} et un second transistor NMOS N_{M2} montés en série entre la borne de la tension d'alimentation V_{DD} et la borne de masse V_{SS}. La source du second transistor P_{M2} est reliée directement à la borne de la tension d'alimentation V_{DD}, alors que la source du second transistor N_{M2} est reliée directement à la borne de masse V_{SS}. La grille de ces deux transistors N_{M2} et P_{M2} est commandée par le signal de mémorisation L_en, ainsi que la grille du premier transistor PMOS P_{M1}, alors que le drain des deux transistors commande la grille du premier transistor NMOS N_{M1}.

Le second inverseur rapide de la cellule mémoire 6 comprend également deux transistors MOS montés en série entre la borne de la tension d'alimentation V_{DD} et la borne de masse V_{SS}. La source du troisième transistor PMOS P_{M3} est reliée directement à la borne de la tension d'alimentation V_{DD}, alors que la source du troisième transistor NMOS N_{M3} est reliée directement à la borne de masse V_{SS}. La grille de ces deux transistors N_{M3} et P_{M3} est reliée à la source des premiers transistors N_{M1} et P_{M1}, alors que le drain de ces deux transistors N_{M3} et P_{M3} constitue la sortie O de l'unité à décalage du niveau de tension 2.

Le troisième inverseur faible de la cellule mémoire 6 est relié en sens inverse entre la sortie et l'entrée du second inverseur. Ce troisième inverseur faible est composé d'une paire de transistors NMOS N_{M4} et N_{M5} en série et d'une paire de transistors PMOS P_{M4} et P_{M5} en série. Ces deux paires de transistors sont montées en série entre la borne de la tension d'alimentation V_{DD} et la borne de masse V_{SS}. La source du quatrième transistor PMOS P_{M4} est reliée directement à la borne de la tension d'alimentation, alors que la source du quatrième transistor NMOS N_{M4} est reliée directement à la borne de masse. Le drain du quatrième transistor PMOS P_{M4} est relié à la source du cinquième transistor P_{M5}, alors que le drain du quatrième transistor NMOS N_{M4} est relié à la source du cinquième transistor NMOS N_{M5}. Le drain des cinquièmes transistors N_{M5} et P_{M5} est relié à l'entrée du second inverseur, c'est-à-dire à la grille des troisièmes transistors N_{M3} et P_{M3}, alors que la grille des transistors N_{M4}, N_{M5}, P_{M4} et P_{M5} est reliée à la sortie du second inverseur, c'est-à-dire à la sortie O de l'unité à décalage du niveau de tension 2.

Il est à noter que l'agencement des deux paires de transistors du troisième inverseur a été choisi pour définir deux transistors PMOS et NMOS à grande longueur L de canal et courte largeur W de canal. Par contre les transistors PMOS et NMOS des premier et second inverseurs sont définis en comparaison avec de courte longueur L de canal et de grande largeur W de canal. Toutefois comme cet agencement est bien connu dans ce domaine technique, il ne sera pas expliqué en plus grand détail.

A partir de la description qui vient d'être faite, plusieurs variantes de réalisation du dispositif de sauvegarde et de son procédé de mise en action peuvent être conçues par l'homme du métier sans sortir du cadre de l'invention définie par les revendications. Le signal de blocage des moyens de blocage peut survenir à tout moment selon une programmation de la logique du circuit intégré ou de manière spontanée au passage du mode de fonctionnement normal au mode de repos après mémorisation de la configuration des terminaux de sortie. La tension d'alimentation du circuit intégré peut être d'un niveau inférieur ou supérieur à la tension régulée interne, qui est coupée dans le mode de repos du dispositif de sauvegarde.

## Revendications

1. Dispositif de sauvegarde (1) de la configuration de terminaux d'un circuit intégré à basse consommation, le dispositif comprenant au moins une unité à décalage de niveau de tension (2, 2', 2", 2"'), qui comprend un étage d'entrée recevant un signal de données ou de contrôle (i), et qui est alimenté sous une tension régulée interne (V_{REG}), et une partie de transfert d'un état d'une fonction en sortie selon l'état du signal de données ou de contrôle, qui est alimentée sous une tension d'alimentation (V_{DD}) du circuit intégré, et un étage de sortie (3) alimenté sous la tension d'alimentation du circuit intégré, qui est relié à la sortie (O) de l'unité à décalage de niveau de tension et connecté à au moins une plage de contact externe (S_{P}) du circuit intégré,
**caractérisé en ce que** le dispositif de sauvegarde comprend plusieurs unités à décalage de niveau de tension (2, 2', 2", 2"') reliés en sortie à l'étage de sortie, les unités à décalage de niveau de tension comprenant chacune une cellule mémoire (6) alimentée par la tension d'alimentation, pour mémoriser l'état de sortie d'une fonction spécifique de l'unité à décalage de niveau respective dans un mode de repos du circuit intégré où la tension régulée est coupée.

2. Dispositif de sauvegarde (1) selon la revendication 1, **caractérisé en ce que** chaque cellule mémoire (6) est reliée en sortie (OUT) de la partie de transfert d'un état d'une fonction spécifique de l'unité à décalage du niveau de tension correspondante.

3. Dispositif de sauvegarde (1) selon l'une des revendications précédentes, **caractérisé en ce qu'**il comprend au moins deux unités à décalage du niveau de tension, une première unité (2) ayant pour fonction de transmettre un signal de données (d_{OUT}) en sortie à l'étage de sortie (3) dans un mode de fonctionnement normal, et une seconde unité (2') ayant pour fonction de fournir un premier signal de contrôle (oe) en sortie à l'étage de sortie pour commander la transmission du signal de données jusqu'à la plage de contact externe (S_{P}) du circuit intégré, et **en ce que** chaque cellule mémoire (6) des deux unités est commandée par un même signal de mémorisation (L_en) pour mémoriser l'état des terminaux de sortie des unités pour le mode de repos.

4. Dispositif de sauvegarde (1) selon la revendication 3, **caractérisé en ce qu'**il comprend en outre une troisième unité à décalage du niveau de tension (2") ayant pour fonction de commander par un second signal de contrôle (n_en_pull_up) à l'étage de sortie (3) un tirage vers le haut de la plage de contact externe (S_{P}) du circuit intégré dans un mode de fonctionnement normal, et **en ce qu'**il comprend en outre une quatrième unité à décalage du niveau de tension (2"') ayant pour fonction de commander par un troisième signal de contrôle (en_pull_down) à l'étage de sortie un tirage vers la bas de la plage de contact externe (S_{P}) du circuit intégré dans un mode de fonctionnement normal.

5. Dispositif de sauvegarde (1) selon l'une des revendications 3 et 4, **caractérisé en ce que** l'étage de sortie (3) comprend une porte de transfert à trois états (4) recevant en entrée un signal de données décalé en tension de la première unité à décalage du niveau de tension (2) dans un mode de fonctionnement normal, ladite porte de transfert à trois états étant commandé par un premier signal de contrôle (oe) fourni par la seconde unité à décalage du niveau de tension (2'), la sortie de la porte de transfert étant reliée à la plage de contact externe (S_{P}), et **en ce que** l'étage de sortie comprend un premier transistor PMOS (P_{S}) et un second transistor NMOS (N_{S}) montés en série entre une borne de tension d'alimentation (V_{DD}) et une borne de masse (V_{SS}), et une résistance (R_{P}) reliant le drain des deux transistors à la plage de contact externe, le premier transistor étant commandé par la troisième unité à décalage du niveau de tension (2") pour opérer un tirage vers le haut, alors que le second transistor étant commandé par la quatrième unité à décalage du niveau de tension (2"') pour opérer un tirage vers le bas.

6. Dispositif de sauvegarde (1) selon l'une des revendications précédentes, **caractérisé en ce que** chaque unité à décalage du niveau de tension comprend dans la partie de transfert d'un état d'une fonction en sortie, des moyens de blocage (N_{B1}, N_{B2}, N_{B3}, P_{B1}, P_{B2}) alimentés à la tension d'alimentation (V_{DD}) du circuit intégré, ces moyens de blocage étant prévus pour couper tous les courants transversaux des transistors d'une partie à décalage du niveau dans un mode de repos.

7. Dispositif de sauvegarde (1) selon la revendication 6, **caractérisé en ce que** les moyens de blocage de chaque unité à décalage du niveau de tension sont commandés par un même signal de blocage (n_block) pour permettre de couper tous les courants transversaux et imposer un état défini en sortie de chaque unité indépendamment de tout signal de données ou de contrôle (i) dans un mode de repos, quand la tension régulée interne est coupée.

8. Procédé de mise en action d'un dispositif de sauvegarde (1) de la configuration de terminaux d'un circuit intégré à basse consommation selon l'une des revendications précédentes, **caractérisé en ce qu'**il comprend pour le passage d'un mode de fonctionnement normal à un mode de repos et inversement, les étapes consistant à :
- commander au moyen d'un signal de mémorisation (L_en) la mémorisation par chaque cellule mémoire (6) du dernier état de sortie (O) des terminaux de sortie des unités à décalage du niveau de tension (2, 2', 2", 2"'),
- commander le passage du mode de fonctionnement normal au mode basse consommation ou de repos, dans lequel la tension régulée interne (V_{REG}) est coupée ou devient flottante, le dernier état de sortie des terminaux étant maintenu par les cellules mémoires activées par le signal de mémorisation,
- réveiller après un laps de temps déterminé ou suite à une commande externe, le dispositif de sauvegarde pour le passage du mode de repos au mode de fonctionnement normal avec la tension régulée en fonction, le dernier état de sortie des terminaux de sortie étant maintenu par les cellules mémoires activée par le signal de mémorisation, et
- désactiver le signal de mémorisation pour changer selon les signaux de données ou de contrôle la configuration des terminaux de sortie de chaque unité à décalage du niveau de tension.

9. Procédé selon la revendication 8, pour lequel le dispositif de sauvegarde comprend des moyens de blocage des courants transversaux de la partie de transfert d'un état d'une fonction en sortie dans chaque unité à décalage du niveau de tension, **caractérisé en ce que** les moyens de blocage sont mis en fonction après la commande par le signal de mémorisation (L_en) de la mémorisation de la configuration des terminaux de sortie dans chaque cellule mémoire (6), et **en ce que** les moyens de blocage deviennent inactifs après le réveil du dispositif de sauvegarde, mais avant la désactivation du signal de mémorisation.

10. Procédé selon la revendication 9, **caractérisé en ce que** les moyens de blocage sont mis en fonction au même moment de la commande du passage du mode de fonctionnement normal au mode de repos ou un laps de temps suivant cette opération.
